Europäisches Patentamt

European Patent Office

Office européen des brevets

(19)

(11) **EP 0 721 118 B1**

(12) **FASCICULE DE BREVET EUROPEEN**

(45) Date de publication et mention
de la délivrance du brevet:
**06.11.2002 Bulletin 2002/45**

(51) Int Cl.⁷: **G02B 6/16**

(21) Numéro de dépôt: **95402806.4**

(22) Date de dépôt: **13.12.1995**

(54) **Procédé de formation d'un réseau dispositif dans une fibre optique**

Verfahren zur Herstellung eines Gitterelements in einer optischen Faser

Method of forming a grating element in an optical fibre

(84) Etats contractants désignés:
**DE DK FR GB IT NL**

(30) Priorité: **15.12.1994 FR 9415132**

(43) Date de publication de la demande:
**10.07.1996 Bulletin 1996/28**

(73) Titulaire: **ALCATEL**
**75008 Paris (FR)**

(72) Inventeurs:
• **Chesnoy, Jose**
  **F-75014 Paris (FR)**
• **Riant, Isabelle**
  **F-91120 Palaiseau (FR)**
• **Sansonetti, Pierre**
  **F-91120 Palaiseau (FR)**

(74) Mandataire: **Lamoureux, Bernard et al**
**Compagnie Financiere Alcatel,**
**Département D.P.I.,**
**30, avenue Kléber**
**75016 Paris (FR)**

(56) Documents cités:
**EP-A- 0 606 726       WO-A-91/15787**
**WO-A-92/07289        AT-A- 382 026**
**GB-A- 2 272 075       US-A- 4 725 110**

• **ELECTRONICS LETTERS., vol. 30, no. 9, 28 Avril 1994 ENAGE GB, pages 707-709, S.J.MIHAILOV ET.AL. 'Recording of efficient high-order Bragg reflectors in optical fibres by mask image projection and single pulse exposure with an excimer laser'**
• **ELECTRONICS LETTERS., vol. 29, no. 18, 2 Septembre 1993 ENAGE GB, pages 1614-1615, J.D.PROHASKA ET.AL. 'Magnification of mask fabricated fibre bragg gratings'**
• **IEE PROCEEDINGS J. OPTOELECTRONICS, vol. 141, no. 2, Avril 1994 STEVENAGE GB, pages 141-144, P.Y.FONJALLAZ ET.AL. 'Direct determination of main fibre Bragg grating parameters using OLCR'**

## Description

La présente invention concerne la technologie des fibres optiques et en particulier un procédé de formation d'un réseau dispersif dans une fibre optique.

Dans la technologie des fibres optiques utilisées pour la transmission d'informations, il est quelquefois nécessaire d'introduire une variation périodique de l'indice de réfraction de la fibre optique de façon à l'utiliser comme réflecteur, notamment pour obtenir un filtre à spectre large pour compenser une forte dispersion chromatique sur une grande bande spectrale grâce à des réflexions étagées des diverses composantes spectrales. La réalisation d'une telle variation d'indice constitue l'impression d'un réseau de Bragg. Elle résulte d'une irradiation de la fibre par un système de franges d'interférence formé par deux faisceaux secondaires ultraviolets issus d'un même faisceau primaire et inclinés symétriquement. L'intervalle entre franges définit le pas du réseau.

Pour réaliser un réseau de Bragg à pas variable, il existe plusieurs solutions dans la technique antérieure. Une première solution consiste à illuminer un "réseau de phase" formé de traits parallèles gravés dans une plaque transparente par un faisceau primaire parallèle. Les épaisseurs des traits sont choisis pour supprimer le faisceau diffracté d'ordre 0. Les faisceaux d'ordre +1 et -1 constituent les deux faisceaux secondaires. Une variation discrète du pas entre segments successifs du réseau de phase entraîne une variation correspondante du pas du réseau de Bragg. Malheureusement, la différence de pas entre deux segments successifs du réseau de phase peut difficilement descendre au dessous de 1nm. Cette différence est bien trop élevée pour réaliser un filtre à forte dispersion chromatique puisqu'il peut être nécessaire dans ce cas d'obtenir une différence de pas inférieure à $10^{-11}$ m soit 0,1 Angström.

Une autre méthode de la technique antérieure, décrite notamment dans EP-A-0 604 039, consiste à former les deux faisceaux secondaires par deux miroirs à partir d'un faisceau primaire parallèle. Une décollimation d'un faisceau secondaire provoque une variation longitudinale du pas du système de franges. Mais le réseau imprimé obtenu par cette méthode est trop court, ce qui limite par exemple la bande spectrale d'un compensateur de dispersion chromatique.

On connaît également, par le document US-A-4 725 110, un procédé de formation de deux réseaux dispersifs distincts, indépendants l'un de l'autre, obtenu par deux expositions successives d'une fibre optique photosensible à une lumière apte à induire un effet photoréfractif dans cette fibre optique, un déplacement des éléments du système optique d'exposition étant effectué entre les deux expositions , en particulier un écartement ou un rapprochement de deux miroirs, de manière à changer le pas du système de franges d'interférence entre les deuux expositions.

On connaît encore, par le document GB-A-2 272 075, un procédé de formation d'un réseau dispersif unique constitué d'au moins deux segments de réseau adjacents en cohérence de phase l'un avec l'autre, procédé dans lequel le pas du système de franges d'interférence est identique pour les deux expositions.

Un but de la présente invention est notamment de permettre d'imprimer un réseau de Bragg pouvant être utilisé efficacement pour la compensation d'une dispersion chromatique.

Le procédé selon la présente invention, tel que défini dans la revendication 1, comprend, dans son préambule, une série d'opérations qui sont connues du document GB-A-2 272 075, et est caractérisé par une modification du système optique en concomitance avec le déplacement relatif de la fibre optique entre les deux expositions, pour donner au pas du système de franges d'interférence et du deuxième segment de réseau dispersif une deuxième valeur présentant une différence par rapport à la première valeur de pas, de façon à former un réseau dispersif global à pas variable, ladite modification étant obtenue par déplacement du ou d'un autre des éléments optiques constitutifs dudit système optique.

Des modes de réalisation particuliers du procédé de l'invention sont décrits dans les revendications dépendantes.

Les buts, objets et caractéristiques du dispositif selon l'invention ressortiront mieux à la lecture de la description suivante en référence aux dessins dans lesquels:

la figure 1 est une représentation schématique d'un premier mode de réalisation du dispositif d'impression selon l'invention,
la figure 2 est une représentation schématique de l'ensemble formé par le système optique, le réseau de phase et la fibre optique du dispositif d'impression illustré sur la figure 1,
la figure 3 est une représentation schématique d'un deuxième mode de réalisation du dispositif d'impression selon l'invention, et
la figure 4 est une représentation schématique d'un troisième mode de réalisation du dispositif d'impression selon l'invention.

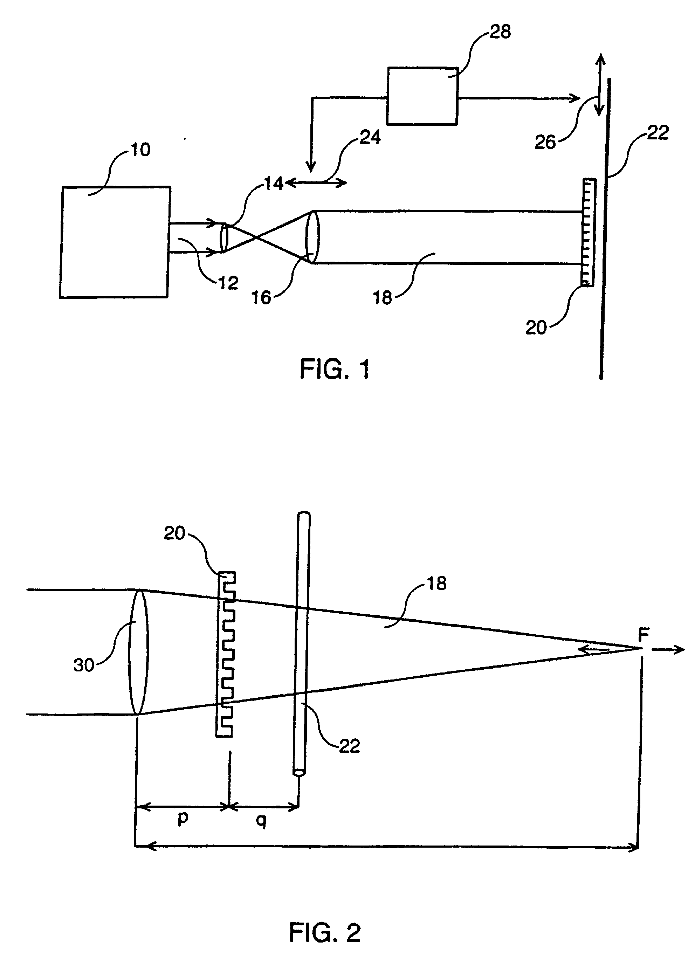

Dans un premier mode de réalisation du dispositif de l'invention représenté sur la figure 1, un générateur de faisceau laser 10 fournit un faisceau laser (12) de lumière ultraviolette de longueur d'onde λ=240 nm. Le générateur 10 peut être du type laser à colorant doublé pompé par un laser à excimètre ou de tout autre type.

Le faisceau laser 12 traverse ensuite un système optique formé d'une première lentille 14 et d'une deuxième lentille 16. Dans un tel système, au départ afocal, le faisceau parallèle 12 est focalisé au foyer de la première lentille 14 qui est également le foyer de la deuxième lentille 16. Par conséquent, la deuxième lentille 16 fournit un faisceau laser primaire 18 parallèle c'est à dire convergeant à l'infini.

Le faisceau primaire 18 est appliqué ensuite à un réseau de phase 20 de pas fixe, destiné à générer des franges d'interférence. Les franges d'interférence (non montrées) sont imprimées dans la fibre optique 22 par effet photo-réfractif.

On doit noter que dans l'autre dimension, c'est à dire la dimension perpendiculaire à la figure, on focalise le faisceau primaire 18 sur la fibre 22 au moyen d'une lentille cylindrique (non montrée) dont la courbure se trouve dans le plan perpendiculaire à la figure. Cette focalisation destinée à concentrer l'énergie lumineuse sur la fibre optique est donc indépendante du système afocal formé des lentilles 14 et 16.

Dans ce premier mode de réalisation, la focale du système optique formé de lentilles 14 et 16 est rendue variable en déplaçant la lentille 16 dans le sens indiqué par la flèche 24. Le même effet pourrait d'ailleurs être obtenu en déplaçant la lentille 14. En même temps que l'on déplace la lentille 16, on provoque le déplacement de la fibre selon la flèche 26. Le pas du réseau de Bragg imprimé dans la fibre optique dépendant de la focale du système optique, les différents pas à imprimer sur des segments successifs de la fibre optique sont réalisés par variation de la focale. Les déplacements de la lentille 16 (ou de la lentille 14) et de la fibre optique 22 sont sous la commande de l'unité de commande de déplacement 28 et se font de manière synchronisée. Ainsi pour une position donnée de la lentille 16 (ou de la lentille 14) et de la fibre optique 22, il y a impression d'un réseau de Bragg d'un pas donné sur un segment de la fibre optique. Puis, l'unité de commande de déplacement 28 commande le déplacement concomitant de la lentille 16 (ou de la lentille 14) et de la fibre optique 22. Cette dernière est déplacée avec une grande précision de façon à ce qu'un nouveau segment, consécutif à celui qui vient d'être imprimé, se trouve prêt à être imprimé. Pendant le déplacement de la fibre optique, la lentille 16 (ou la lentille 14) aura été déplacée de manière à ce que sa focale étant modifiée, le nouveau segment de fibre optique soit imprimé avec le nouveau pas dépendant de la nouvelle focale du système optique.

Dans le mode de réalisation qui vient d'être décrit, le réseau de phase doit avoir une longueur au moins égale à celle d'un segment du réseau de Bragg à imprimer. Par contre, le réseau de Bragg n'est pas limité et dépend de la longueur de fibre optique que l'on désire imprimer. En tout état de cause, cette réalisation permet l'impression sur de grandes longueurs de fibre et donc la réalisation d'un compensateur de dispersion chromatique à grande bande passante.

Lorsque la lentille du système optique est déplacée, il y a déplacement du point de convergence F du faisceau primaire 18 comme illustré schématiquement sur la figure 2. Si p est la distance entre le système optique représenté par la lentille 30 et le réseau de phase 20, q la distance entre le réseau de phase 20 et la fibre optique 22, et f la focale du système optique, la variation relative de la longueur d'onde de Bragg du réseau de Bragg par rapport à un éclairement collimaté (focale infinie) est alors donnée par

$$\Delta\lambda/\lambda = -q/(f-p)$$

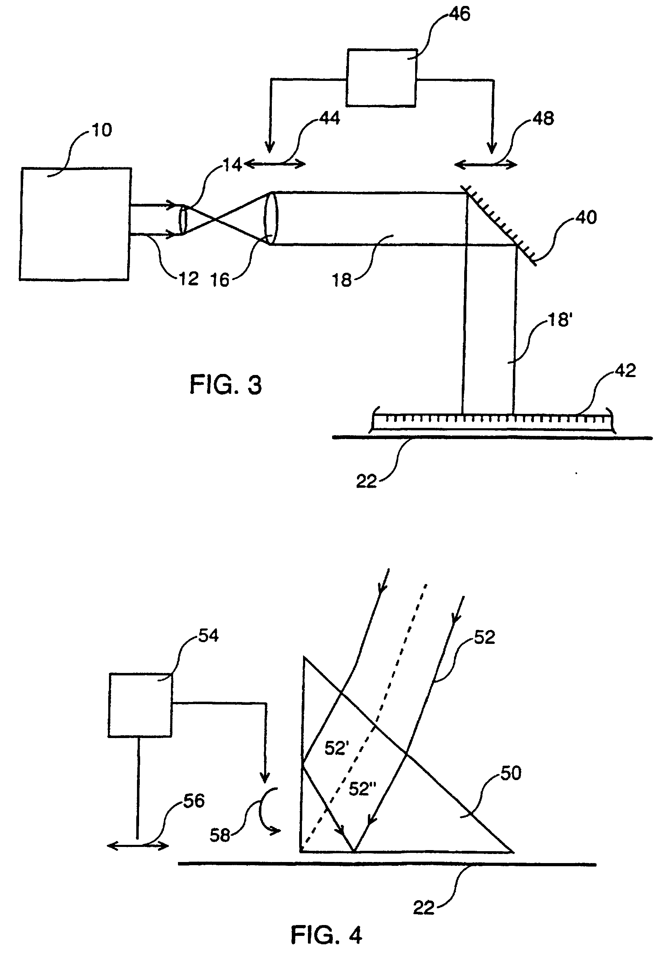

Un deuxième mode de réalisation du dispositif selon l'invention est illustré sur la figure 3. Dans ce mode de réalisation le faisceau laser 12 fourni par le générateur 10, est transformé par le système optique constitué des deux lentilles 14 et 16 pour donner le faisceau primaire 18 de la même façon que dans le premier mode de réalisation illustré sur la figure 1. Mais le faisceau primaire 18 est ici réfléchi par un miroir 40 placé à 45° par rapport au faisceau 18. Le miroir 40 réfléchit le faisceau primaire à 90° vers un réseau ou masque de phase 42 contigu à la fibre optique 22 à imprimer.

Contrairement au premier mode de réalisation, dans le mode illustré sur la figure 3, le réseau de phase et la fibre optique sont fixes. Mais en même temps que l'unité de commande de déplacement 46 commande le déplacement de la lentille 16 du système optique pour faire varier la focale, elle commande également le déplacement en translation du miroir 40 (selon la flèche 48) suivant le même axe de déplacement que la lentille 16. Le déplacement concomitant du miroir 40 et de la lentille 16 est tel que le faisceau réfléchi 18' se déplace sur le segment adjacent à celui qui a été imprimé précédemment pendant que la lentille 16 s'est déplacée d'une quantité nécessaire pour obtenir la variation discrète du pas de réseau de Bragg selon l'équation mentionnée plus haut.

Dans ce deuxième mode de réalisation, illustré sur la figure 3, il est nécessaire que le réseau de phase ait une longueur au moins égale à celle du réseau à imprimer. C'est la raison pour laquelle seule une partie tronquée du réseau de phase est représentée sur la figure.

On doit noter que le deuxième mode de réalisation de la figure 3 permet facilement non seulement de juxtaposer des réseaux élémentaires imprimés dans la fibre optique, mais aussi d'obtenir la cohérence de phase entre ces réseaux du fait que le réseau de phase et la fibre optique restent fixes l'un par rapport à l'autre. Ce résultat peut également être obtenu en utilisant le mode de réalisation illustré sur la figure 1 dans lequel le réseau de phase, dans ce cas aussi long que la fibre optique à imprimer, se déplace longitudinalement de façon solidaire avec la fibre optique.

Dans un troisième mode de réalisation, représenté sur la figure 4, le système optique à lentilles a été remplacé par un prisme 50. Le faisceau primaire incident 52 est réfracté à son entrée dans le prisme 50. Comme illustré sur la figure, la partie gauche 52' du faisceau réfracté est réfléchie par le bord interne du prisme alors que la partie droite 52" du faisceau réfracté n'est pas réfléchie et arrive directement sur le bord inférieur du prisme. Il y a donc formation de deux faisceaux secondaires, et par conséquent, formation de franges d'interférence qui servent à imprimer un réseau de Bragg dans la fibre optique 22.

Lorsqu'on désire imprimer un segment ayant un pas différent, une unité de commande de déplacement 54 commande de façon concomitante le déplacement de la fibre optique longitudinalement dans le sens de la flèche 56 et la rotation du prisme dans le sens de la flèche courbe 58.

Cette rotation fait varier l'angle d'incidence du faisceau 52 par rapport au prisme et donc les inclinaisons des deux faisceaux secondaires induits par le prisme. Cette variation (symétrique) des angles des deux faisceaux secondaires induit alors un pas de réseau de Bragg ayant varié de façon discrète d'un segment à l'autre de la fibre optique.

Bien que technologiquement plus difficile à réaliser, le troisième mode de réalisation peut être simplifié en ne gardant du prisme que le miroir (sur lequel se réfléchit la partie gauche 52' du faisceau), et en faisant subir une rotation à ce miroir, selon la flèche 58, pour faire varier le pas du réseau de Bragg de la façon expliquée précédemment.

Il est évident que des modifications peuvent être apportées aux différents modes de réalisation du dispositif d'impression sans sortir du cadre de l'invention. Ainsi, l'intensité du faisceau d'impression au niveau de la fibre optique peut être modulée pas à pas, par exemple en déplaçant la lentille cylindrique de focalisation sur la fibre optique, ceci dans le but de réaliser une apodisation du réseau de Bragg obtenu.

**Revendications**

1. Procédé de formation d'un réseau dispersif dans une fibre optique (22) photosensible, ce procédé comportant les opérations de :

   - formation d'un faisceau primaire (12, 18; 52) constitué d'une lumière apte à induire un effet photoréfractif dans ladite fibre optique,
   - interposition sur le trajet dudit faisceau primaire d'un système optique constitué d'un (50) ou de plusieurs (14, 16, 20; 14, 16, 20, 42) éléments optiques, ledit (50) ou l'un (20; 42) desdits éléments optiques étant apte à diviser ce faisceau en deux faisceaux secondaires (52', 52") formant ensemble un système de franges d'interférence ayant un pas présentant une première valeur,
   - exposition d'un premier segment de ladite fibre optique audit système de franges d'interférence pour y imprimer un premier segment de réseau dispersif ayant un pas présentant également ladite première valeur,

   - déplacement relatif (26; 48; 56) de ladite fibre optique selon une longueur de cette fibre par rapport audit système de franges d'interférence pour permettre d'exposer un deuxième segment de cette fibre audit système de franges d'interférence, et
   - exposition de ce deuxième segment de la fibre optique audit système de franges d'interférence pour y imprimer un deuxième segment de réseau dispersif,
   - ledit déplacement relatif (26; 48; 56) de la fibre optique entre lesdites deux expositions étant effectué de manière à réaliser une cohérence de phase entre lesdits premier et deuxième segments de réseau de façon à former un réseau dispersif global unique,

   ledit procédé étant **caractérisé par** une modification (24; 44; 58) dudit système optique (14, 16, 20; 14, 16, 40, 42; 50) en concomitance avec ledit déplacement relatif de la fibre optique entre lesdites deux expositions, pour donner au pas dudit système de franges d'interférence et dudit deuxième segment de réseau dispersif une deuxième valeur présentant une différence par rapport à ladite première valeur de pas, de façon à former un réseau dispersif global à pas variable, ladite modification étant obtenue par déplacement (24; 44; 58) dudit (50) ou d'un autre (16) desdits éléments optiques constitutifs dudit système optique.

2. Procédé selon la revendication 1, **caractérisé par le fait que** ledit élément optique (42) pour former lesdits faisceaux secondaires est constitué par un premier et un deuxième segments d'un réseau auxiliaire global présentant tous deux une même valeur de pas uniforme, ledit autre élément optique (16) déplacé (48) pour assurer le changement de pas désiré dudit système de franges d'interférence étant disposé en amont dudit réseau auxiliaire global (42) pour agir sur ledit faisceau primaire (12, 18), ledit réseau auxiliaire global restant solidaire de la fibre optique durant ledit déplacement relatif de cette dernière par rapport au sytème de franges d'interférence entre les deux expositions.

3. Procédé selon la revendication 2, ledit réseau auxiliaire global (42) étant un réseau de phase.

**Patentansprüche**

1. Verfahren zur Bildung eines lichtstreuenden Gitters in einem photoempfindlichen Lichtwellenleiter (22), wobei das Verfahren die folgenden Vorgänge umfasst:

   - Bildung eines Primärstrahls (12,18; 52), bestehend aus einem Licht, das zur Auslösung eines Fotorefraktionseffekts in dem Lichtwellenleiter geeignet ist,

- Einfügung in den Weg Primärstrahls eines optischen Systems, bestehend aus einem (50) oder mehreren (14, 16, 20; 14, 16, 20, 42) optischen Elementen, wobei das optische Element (50) oder das eine (20; 42) der optischen Elemente zum Teilen dieses Strahls in zwei Sekundärstrahlen (52', 52''), die zusammen ein System von Interferenzstreifen mit einer Unterteilung, die einen ersten Wert aufweist, bilden,
- Exposition eines ersten Segments der optischen Faser gegenüber dem Interferenzstreifensystem unter Aufdrucken darauf eines ersten lichtstreuenden Gittersegments mit einer Unterteilung, die ebenfalls den ersten Wert aufweist,
- relative Verschiebung (26; 48; 56) des Lichtwellenleiters, entsprechend einer Länge dieser Faser, bezüglich des Interferenzstreifensystems, um die Exposition eines zweiten Segments dieser Faser gegenüber dem Interferenzstreifensystem zu ermöglichen, und
- Exposition dieses zweiten Segments des Lichtwellenleiters gegenüber dem Interferenzstreifensystem unter Aufdrucken darauf eines zweiten lichtstreuenden Gittersegments,
- wobei die relative Verschiebung (26; 48; 56) des Lichtwellenleiters zwischen den beiden Expositionen unter Herbeiführung einer Phasenkohärenz zwischen erstem und zweitem Gittersegment durchgeführt wird, derart, dass ein einziges lichtstreuendes Gesamtgitter gebildet wird,

wobei das Verfahren **gekennzeichnet ist durch** eine mit der relativen Verschiebung des Lichtwellenleiters zwischen den beiden Expositionen einhergehenden Modifikation (24; 44; 58) des optischen Systems (14, 16, 20; 14, 16, 40, 42; 50), um der Unterteilung des Interferenzstreifensystems und des zweiten lichtstreuenden Gittersegments einen zweiten Wert zu verleihen, der einen Unterschied zum ersten Unterteilungswert aufweist, derart, daß ein lichtstreuendes Gesamtgitter mit variabler Unterteilung gebildet wird, wobei die Modifikation **durch** Verschiebung (24; 44; 58) des (50) oder eines anderen (16) der optischen Bauelemente des optischen Systems erhalten wird.

2. Verfahren nach Anspruch 1, **dadurch gekennzeichnet, daß** das optische Element (42) zum Bilden der Sekundärstrahlen aus einem ersten und einem zweiten Segment eines Hilfs-Gesamtgitters dargestellt wird, die beide den gleichen einheitlichen Unterteilungswert aufweisen, wobei das andere optische Element (16), das zur Sicherstellung der gewünschten Unterteilungsänderung des Interferenzstreifensystems verschoben wird (48), unter Einwirkung auf den Primärstrahl (12, 18) dem Hilfs-Gesamtgitter (42) vorgeschaltet angeordnet wird, wobei das Hilfs-Gesamtgitter während der relativen Verschiebung dieses Vorgenannten bezüglich des Interferenzstreifensystems zwischen den beiden Expositionen mit dem Lichtwellenleiter innerlich verbunden bleibt.

3. Verfahren nach Anspruch 2, wobei das Hilfs-Gesamtgitter (42) ein Phasengitter ist.

## Claims

1. A method of forming a dispersing grating in a photosensitive optical fiber (22), which method includes the following steps:

    forming a primary beam (12, 18; 52) constituted by light suitable for inducing a photo-refractive effect in said optical fiber;
    interposing on the path of said primary beam an optical system constituted by one (50) or a plurality (14, 16, 20; 14, 16, 20, 42) of optical elements, said optical element (50) or one (20; 42) of said optical elements being suitable for splitting the beam into two secondary beams (52', 52'') together forming a system of interference fringes having a pitch exhibiting a first value;
    exposing a first segment of said optical fiber to said system of interference fringes so as to inscribe a first segment of dispersing grating having a pitch also exhibiting said first value;
    displacing (26; 48; 56) said optical fiber over a length of said fiber relative to said system of interference fringes having said second pitch value so as to make it possible to expose a second segment of the fiber to said system of interference fringes; and
    exposing the second segment of the optical fiber to said system of interference fringes so as to inscribe therein a second segment of dispersing grating;
    said relative displacement (26; 48; 56) of the optical fiber between said two exposures being performed in such a manner as to achieve phase coherence between said first and second grating segments so as to form a single overall dispersing grating;
    said method being **characterized by** modifying (24; 44; 58) said optical system (14, 16, 20; 14, 16, 40, 42; 50) in conjunction with said relative displacement of the optical fiber between said two exposures so as to give to the pitch of said system of interference fringes and of said second segment of dispersing grating a second value exhibiting a difference relative to said first pitch value so as to form an overall dispersing grating of varying pitch, said modification being obtained by displacing (24; 44; 58) said optical element (50) or another one (16) of said optical elements constituting said optical system.

2. A method according to claim 1, **characterized by** the fact that said optical element (42) for forming said secondary beams is constituted by first and second segments of an overall auxiliary grating both having the same uniform pitch value, said other optical element (16) which is displaced (48) to guarantee the desired pitch change of said system of interference fringes being disposed upstream from said overall auxiliary grating (42) so as to act on said primary beam (12, 18), said overall auxiliary grating remaining secured to the optical fiber during said relative displacement of said optical fiber relative to the system of interference fringes between the two exposures.

3. A method according to claim 2, said overall auxiliary grating (42) being a phase grating.

FIG. 1

FIG. 2

FIG. 3

FIG. 4